# EUROPEAN PATENT APPLICATION

(11) **EP 4 776 838 A1**
(43) Date of publication of application: **15.07.2026**
(21) Application number: 26150380.9
(22) Date of filing: 06.01.2026
(51) Int. Cl.: H10W 70/65, H10W 70/68, H10W 90/00

(54) **INTERPOSER SUBSTRATE, PACKAGE STRUCTURE INCLUDING THE SAME, MANUFACTURING METHOD THEREOF, AND ELECTRICAL SYSTEM**

(30) Priority: 09.01.2025 CN 202510039988; 30.12.2025 US 202519436958
(71) Applicant: Shenzhen STS Microelectronics Co., Ltd., Shenzhen 518048 (CN)
(72) Inventor: CHEN, Qiao, Shenzhen 518040 (CN); ZHENG, Nan Nan, Shenzhen 518038 (CN); LIANG, Lin, Shenzhen 518048 (CN)
(74) Representative: Casalonga

(57) **Abstract**

The present disclosure relates to an interposer substrate, a package structure comprising the interposer substrate, a manufacturing method thereof, and an electrical system. An interposer substrate for a package structure is provided that comprises: an insulating body having one or more holes; one or more coupling members disposed on or in the insulating body; and one or more electronic components comprising a first electronic component disposed in a first hole of the one or more holes and electrically coupled to a corresponding first coupling member of the one or more coupling members, the first electronic component being adaptable to be electrically coupled to other members of the package structure external to the interposer substrate through the first coupling member.

## Description

### BACKGROUND

### Technical Field

The present disclosure relates to high reliability/high performance power packaging technology, and more specifically, to an interposer substrate integrated with electronic components, a package structure including the interposer substrate, a manufacturing method thereof, and an electrical system.

### Description of the Related Art

With the demand for higher-performance power modules in various applications, such as electric vehicles (EVs), the structures of power modules have become complex. It is often required to integrate multiple dies and components into one and the same module. However, managing the production and quality of such complex power modules will become problematic.

### BRIEF SUMMARY

According to an aspect of the present disclosure, an interposer substrate for a package structure is provided that comprises: an insulating body having one or more holes; one or more coupling members provided on or in the insulating body; and one or more electronic components comprising a first electronic component which is disposed in a first hole of the one or more holes and electrically coupled to a corresponding first coupling member of the one or more coupling members, the first electronic component being adaptable to be electrically coupled to other members of the package structure external to the interposer substrate through the first coupling member.

In some embodiments, the package structure comprises a power die adaptable to be mounted to a first mounting substrate and positioned between the interposer substrate and the first mounting substrate, and the first coupling member is adaptable to be electrically coupled to an electrode of the die.

In some embodiments, the one or more electronic components further comprise a second electronic component disposed in a second hole of the one or more holes, electrically coupled to a corresponding second coupling member of the one or more coupling members, and adaptable to be electrically coupled to a component bonding portion of the first mounting substrate through the corresponding second coupling member, wherein the die is mounted to a die bonding portion of the first mounting substrate.

In some embodiments, the interposer substrate further includes at least one of: a conductive spacer disposed in a third hole of the one or more holes, the spacer being adaptable to be electrically coupled to an electrode of the die on a side thereof opposite to the first mounting substrate; or a pillar disposed in a fourth hole of the one or more holes, with an end thereof adaptable to be bonded to the first mounting substrate.

In some embodiments, the first hole extends through the insulating body from a first face of the insulating body to a second face of the insulating body opposite the first face, the first coupling member comprises a first conductor portion provided on or in the first face of the insulating body, wherein the first conductor portion comprises a first portion at a sidewall of the first hole, the first portion being electrically connected to an electrode of the first component.

In some embodiments, the first hole extends through the insulating body from a first face of the insulating body to a second face of the insulating body opposite the first face, the first coupling member comprises a first conductor portion provided on or in the first face of the insulating body, wherein the first conductor portion covers at least a portion of the first hole from a side of the first face of the insulating body, the first conductor portion being electrically connected to an electrode of the first component.

In some embodiments, the first hole extends through the insulating body from a first face of the insulating body to a second face of the insulating body opposite the first face, the first coupling member comprises a first conductor portion comprising a first portion filled in the first hole, a second portion extending from the first portion to the first face of the insulating body along a sidewall of the first hole, and a third portion extending from the second portion along the first face of the insulating body, wherein the first portion or the second portion is electrically connected to an electrode of the first component.

In some embodiments, the first hole extends through the insulating body from a first face of the insulating body to a second face of the insulating body opposite the first face, the first coupling member comprises a first conductor portion comprising a first portion and a second portion disposed in the first hole and separated from the first portion, the first portion covering at least a portion of the first hole from a side of the first face of the insulating body, wherein the first portion is electrically connected to an electrode of the first component.

In some embodiments, the second hole extends through the insulating body from a first face of the insulating body to a second face of the insulating body opposite the first face, the second coupling member is filled in the second hole and extends from the first face of the insulating body to the second face of the insulating body, the second coupling member having a recess extending inward from the first face of the insulating body, the second component is at least partially provided in the recess and electrically connected to the second coupling member.

In some embodiments, the second hole extends inward from a first face of the insulating body and does not extend to a second face of the insulating body opposite the first face, the second coupling member covers a surface of the second hole and has a recess extending inward from the first face of the insulating body, the second component is at least partially provided in the recess and electrically connected to the second coupling member.

In some embodiments, the first component comprises a gate resistor adaptable to be electrically coupled to a gate electrode of a die of the package structure through the first coupling member; or the second component comprises a temperature sensing element adaptable to be electrically coupled to a mounting substrate of the package structure.

According to an aspect of the present disclosure, a package structure comprises an interposer substrate according to any embodiment of the present disclosure; a first mounting substrate comprising an insulating body and a conductive layer on a side of the insulating body; and a power die electrically coupled to a die bonding portion of the conductive layer, the die being positioned between the interposer substrate and the first mounting substrate, wherein the first electronic component is electrically coupled, through the first coupling member, to one of: a conductive layer of the first mounting substrate; or an electrode of the power die.

In some embodiments, the package structure further includes: a second mounting substrate provided opposite the first mounting substrate with the interposer substrate interposed therebetween.

According to an aspect of the present disclosure, a manufacturing method for a package structure comprises: providing an interposer substrate comprising: providing an insulating body; forming one or more holes in the insulating body; forming one or more coupling members on or in the insulating body; and disposing one or more electronic components, wherein the one or more electronic components comprise a first electronic component disposed in a first hole of the one or more holes, electrically coupled to a corresponding first coupling member of the one or more coupling members, and adaptable to be electrically coupled to other members of the package structure external to the interposer substrate through the first coupling member.

In some embodiments, the method further includes: providing a first mounting substrate which comprises a die bonding portion and a power die electrically coupled to the die bonding portion; and bonding the interposer substrate to the first mounting substrate, wherein bonding the interposer substrate to the first mounting substrate comprises: electrically coupling the first coupling member to an electrode of the die such that the first electronic component is electrically coupled to the electrode of the die through the first coupling member.

In some embodiments, the one or more electronic components further comprise a second electronic component disposed in a second hole of the one or more holes and electrically coupled to a corresponding second coupling member of the one or more coupling members; bonding the interposer substrate to the first mounting substrate further comprises: electrically coupling the second electronic component to a component bonding portion of the first mounting substrate.

In some embodiments, providing an interposer substrate further comprises: disposing a conductive spacer in a third hole of the one or more holes; and disposing a pillar in a fourth hole of the one or more holes; bonding the interposer substrate to the first mounting substrate further comprises: electrically coupling an end of the spacer to an electrode of the die on a side thereof opposite the first mounting substrate; and bonding an end of the pillar to the first mounting substrate.

In some embodiments, the method further includes: attaching a second mounting substrate to a side of the interposer substrate opposite the first mounting substrate.

In some embodiments, the first hole extends through the insulating body from a first face of the insulating body to a second face of the insulating body opposite the first face, the first coupling member comprises a first conductor portion provided on or in the first face of the insulating body, and wherein the first conductor portion comprises a first portion at a sidewall of the first hole, the first portion being electrically connected to an electrode of the first component.

In some embodiments, the first hole extends through the insulating body from a first face of the insulating body to a second face of the insulating body opposite the first face, the first coupling member comprises a first conductor portion provided on or in the first face of the insulating body, wherein the first conductor portion covers at least a portion of the first hole from a side of the first face of the insulating body.

In some embodiments, the first hole extends through the insulating body from a first face of the insulating body to a second face of the insulating body opposite the first face, the first coupling member comprises a first conductor portion comprising a first portion filled in the first hole, a second portion extending from the first portion to the first face of the insulating body along a sidewall of the first hole, and a third portion extending from the second portion along the first face of the insulating body, wherein the first portion or the second portion is electrically connected to an electrode of the first component.

In some embodiments, the first hole extends through the insulating body from a first face of the insulating body to a second face of the insulating body opposite the first face, the first coupling member comprises a first conductor portion comprising a first portion and a second portion disposed in the first hole and separated from the first portion, the first portion covering at least a portion of the first hole from a side of the first face of the insulating body, and wherein the first portion is electrically connected to an electrode of the first component.

In some embodiments, the second hole extends through the insulating body from a first face of the insulating body to a second face of the insulating body opposite the first face, the second coupling member is filled in the second hole and extends from the first face of the insulating body to the second face of the insulating body, the second coupling member having a recess extending inward from the first face of the insulating body, the second component is at least partially disposed in the recess and electrically connected to the second coupling member.

In some embodiments, the second hole extends inward from a first face of the insulating body and does not extend to a second face of the insulating body opposite the first face, the second coupling member covers a surface of the second hole and has a recess extending inward from the first face of the insulating body, the second component is at least partially disposed in the recess and electrically connected to the second coupling member.

In some embodiments, the first component comprises a gate resistor adaptable to be electrically coupled to a gate electrode of the die through the first coupling member, or the second component comprises a temperature sensing element.

According to an aspect of the present disclosure, an electrical system is provided that includes the package structure according to any embodiment of the present disclosure.

According to aspects and embodiments of the present disclosure, a novel interposer substrate integrated with electronic components, a package structure including the interposer substrate, a manufacturing method thereof, and an electrical system are provided. According to the embodiments of the present disclosure, machinability and design flexibility of power modules, and improve reliability can be improved. In addition, the process steps can be reduced, improving the productivity and yield.

Other features of the present disclosure and advantages thereof will become apparent from the following detailed description of exemplary embodiments thereof, which proceeds with reference to the accompanying drawings.

### BRIEF DESCRIPTION OF THE SEVERAL VIEWS OF THE DRAWINGS

The accompanying drawings, which constitute a part of this specification, illustrate embodiments of the present disclosure and together with the description, serve to explain the principles of the present disclosure.

The present disclosure can be more clearly understood from the following detailed description taken in conjunction with the accompanying drawings, in which:
FIG. 1 shows a schematic cross-sectional view of a double-sided cooling (DSC) package structure;
FIGS. 2A-2J respectively show a schematic cross-sectional view of an interposer substrate for package structure according to an embodiment of the present disclosure;
FIGS. 3A-3F show schematic cross-sectional views of the steps of a manufacturing method of an interposer substrate according to some embodiments of the present disclosure, and FIGS. 3G and 3H show schematic cross-sectional views of some alternative steps of a manufacturing method of an interposer substrate according to an alternative embodiment;
FIGS. 4A-4F show schematic cross-sectional views of the steps of a manufacturing method of an interposer substrate according to some embodiments of the present disclosure, and FIGS. 4G and 4H show schematic cross-sectional views of some alternative steps of a manufacturing method of an interposer substrate according to alternative embodiments;
FIGS. 5A, 5B, and 5C each show a schematic cross-sectional view of a package structure according to some embodiments of the present disclosure;
FIGS. 6A, 6B, and 6C each show a schematic cross-sectional view of a package structure according to some embodiments of the present disclosure;
FIG. 7 shows a schematic flow chart of a manufacturing method of a package structure according to some embodiments of the present disclosure;
FIG. 8 shows a schematic flow chart of a manufacturing method of a package structure according to further embodiments of the present disclosure; and
FIG. 9 shows a schematic diagram of an electrical system according to some embodiments of the present disclosure.

Please note that in the embodiments described below, the like reference numerals are sometimes used across various drawings to denote the like parts or parts having the same functions, and repeated descriptions thereof will be omitted. In this specification, like reference numerals and letters are used to denote like items, and therefore, once an item is defined in one drawing, further discussion thereof is not required in subsequent drawings.

For convenience of understanding, the positions, dimensions, ranges, and the like of the respective structures shown in the drawings and the like do not necessarily indicate actual positions, dimensions, ranges, and the like. Therefore, the disclosures described herein is not intended to be limited to the positions, dimensions, ranges, etc., disclosed in the drawings and the like.

### DETAILED DESCRIPTION

Various exemplary embodiments of the present disclosure will now be described in detail with reference to the accompanying drawings. It should be noted that: the relative arrangement of parts and steps, numerical expressions and numerical values set forth in these embodiments are not intended to limit the scope of the present disclosure, unless specifically stated otherwise. Additionally, techniques, methods, and devices known to those of ordinary skills in the relevant art may not be discussed in detail but should be considered to be part of the specification where appropriate.

It should be appreciated that the following description of at least one exemplary embodiment is merely illustrative and is not intended to be any limitation for the present disclosure, its application, or uses. It should also be appreciated that any implementation described herein as exemplary does not necessarily mean that it is preferred or advantageous over other
implementations. The present disclosure is not limited by any expressed or implied theory presented in the preceding TECHNICAL FIELD, DESCRIPTION OF THE RELATED ART, BRIEF SUMMARY, or DETAILED DESCRIPTION.

In addition, certain terminology may also be used in the following description for the purpose of reference only, and is thus not intended to be limiting. For example, the terms "first," "second," and other such numerical terms referring to structures or components do not imply a sequence or order unless clearly indicated by the context.

It will be further understood that the terms "comprises," "comprising," "includes," "including" and the like, when used herein, specify the presence of stated features, integers, steps, operations, elements, and/or components, but do not preclude the presence or addition of one or more other features, integers, steps, operations, elements, components, and/or groups thereof.

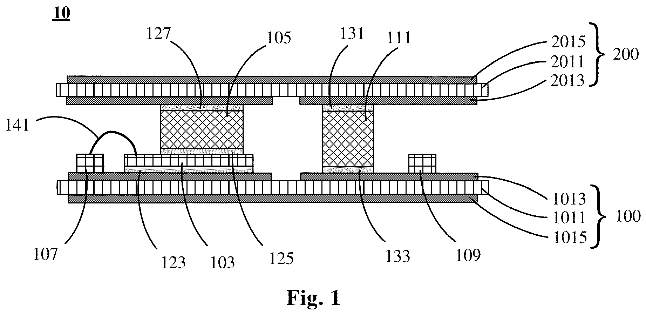

FIG. 1 shows a schematic cross-sectional view of a double-sided cooling (DSC) package structure. As shown in FIG. 1, the DSC package structure 10 may include a first mounting substrate 100 and a second mounting substrate 200. The substrate 100 may include an insulating body 1011 and conductive layers 1013 and 1015 on opposite sides of the insulating body 1011. The substrate 200 may include an insulating body 2011 and conductive layers 2013 and 2015 on opposite sides of the insulating body 2011. The insulating bodies 1011 and 2011 may each be formed of, for example, a ceramic or organic material. The conductive layers 1013, 1015, 2013, and 2015 may each be formed of a metal such as copper or aluminum. As an example, the substrates 100 and 200 may each be, for example, a direct bond copper (DBC) substrate, a direct plated copper (DPC) substrate, an active metal braze (AMB) substrate, a direct bonding aluminum (DBA) substrate, an insulated metal substrate, or the like.

The DSC package structure 10 may further include a die 103, *e.g.,* a power die with a power device formed therein. Here by way of example, the die 103 is mounted to the first mounting substrate 100, *e*.*g*., electrically coupled to the conductive layer 1013 of the substrate 100, as shown in FIG. 1. The power device may include, for example, but not limited to, power MOS transistor, IGBT, power diode, or the like.

The DSC package structure 10 may further include a spacer 105. One end of the spacer 105 is electrically coupled to a side of the die 103 opposite the first mounting substrate 100, *e.g.,* to an electrode of the die 103 through an attachment material *(e.g.,* a solder paste, a conductive sintered material, or the like) 125. The other end of the spacer 105 is electrically coupled to the second mounting substrate 200, for example, to the conductive layer 2013 of the second mounting substrate 200 through an attachment material (*e*.*g*., a solder paste, a conductive sintered material, or the like) 127.

The DSC package structure 10 may further include a gate resistor 107. The gate resistor 107 is electrically coupled to the conductive layer 1013 of the first mounting substrate 100 and is electrically coupled to an electrode (*e.g.,* a gate or control electrode) of the die 103 through a wire 141. The DSC package structure 10 may further include other elements 109, for example, temperature sensing elements, such as negative temperature coefficient (NTC) sensing elements (e.g., thermistors), to sense die temperature. The temperature sensing element 109 may be electrically coupled to the conductive layer 1013 of the first mounting substrate 100. The DSC package structure 10 may further include a support or pillar 111. One end of the pillar 111 is electrically coupled to the first mounting substrate 100, and the other end is electrically coupled to the second mounting substrate 200. In FIG. 1, the pillar 111 is shown as being attached to the conductive layer 1013 of the first mounting substrate 100 and the conductive layer 2013 of the second mounting substrate 200 through attachment materials (*e*.*g*., sintered materials) 131 and 133, respectively.

A typical manufacturing method for the DSC package structure 10 is as follows. First, a die 103 and a gate resistor 107 are attached to a first mounting substrate 100. Then, a conductive spacer 105 is attached to the die. Wire bonding is performed to connect the gate resistor 107 to the die 103 (its gate) through a wire 141. Thereafter, a pillar 111 is attached to the first mounting substrate 100. Subsequently, a second mounting substrate 200 is attached to the structure formed as described above.

The applicant has found that the design of the complex DSC package structure results in that multiple pick-and-place processes are required such that the manufacturing time is long and the process is lengthy and complex, resulting in lower productivity and higher cost. In addition, processing errors are inevitably introduced in a pick-and-place process, and multiple pick-and-place processes bring out an accumulation of errors. It is also noted that the multiple pick-and-place processes, as well as other process steps (*e.g.,* the step of attaching the second mounting substrate), may also result in errors in multiple dimensions, such as pitch or roll errors in addition to planar errors. Therefore, higher manufacturing accuracy of the processes is required, which in turn further reduces the productivity and yield.

The applicant has also found that defects associated with the gate wire 141 are one of the main factors leading to failures of the package structure 10, thereby greatly limiting the improvement of yield. Furthermore, due to design constraints, it is difficult to position the temperature sensing element 109 close to the die 103, as it requires some space and associated wirings, etc., and requires a tradeoff with other design considerations. Therefore, the temperature sensed by it deviates from the actual temperature of the die 103. For some application scenarios, a deviation of just several degrees or even one degree in some critical temperature ranges may lead to different consequences.

At least with respect to one or more of the above and other problems, the applicant has proposed solutions of the embodiments disclosed herein through efforts, originality, and innovation. According to embodiments of the present disclosure, a novel interposer substrate for package structure is proposed. The interposer substrate may be used in conjunction with one or more mounting substrates on which die(s) (*e.g.,* power die(s)) is/are mounted, to form a package structure (*e.g.,* a power module), as will be described in detail later in connection with the figures.

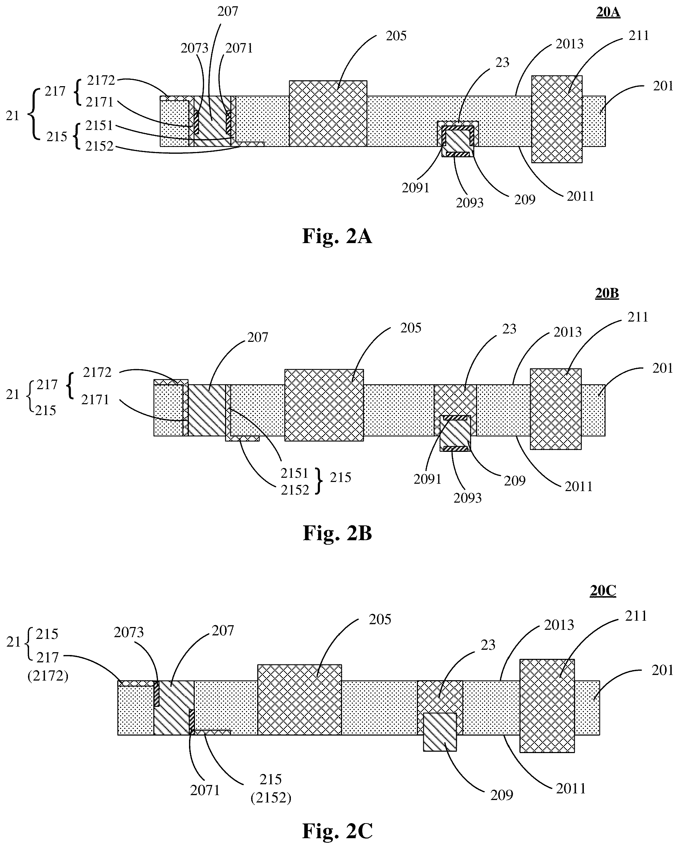

FIGS. 2A-2J respectively show a schematic cross-sectional view of an interposer substrate for package structure according to various embodiments of the present disclosure. In the drawings, the same or similar reference numerals are used for the same elements. Where certain same or similar elements or parts have been described in some of the preceding figures, repeated explanation thereof will be omitted in the subsequent figures and descriptions thereof. It is also to be understood that descriptions in relation to different figures or different embodiments can be likewise or adaptively applied to other figures or other embodiments, which is within the abilities of one of ordinary skill in the art.

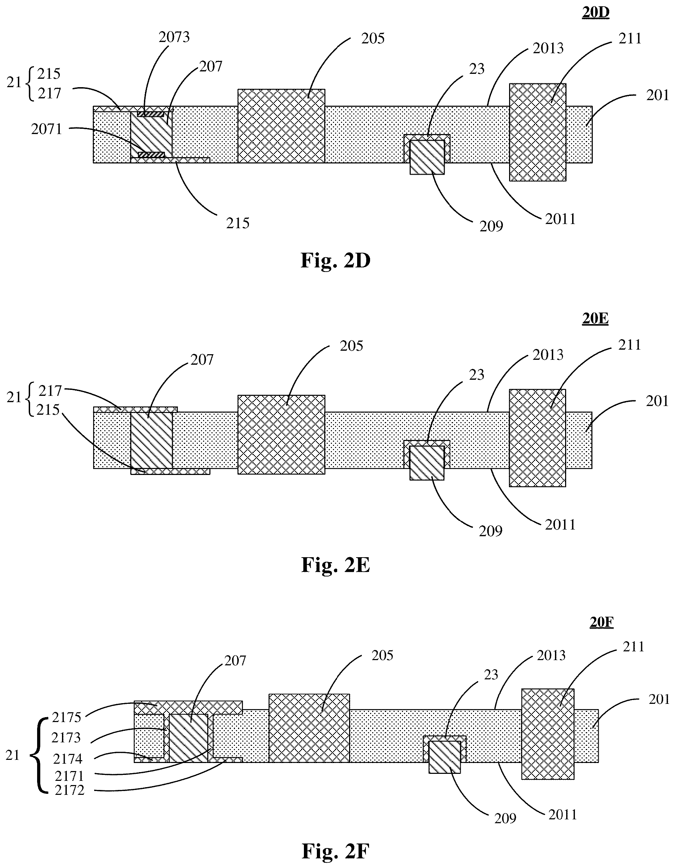

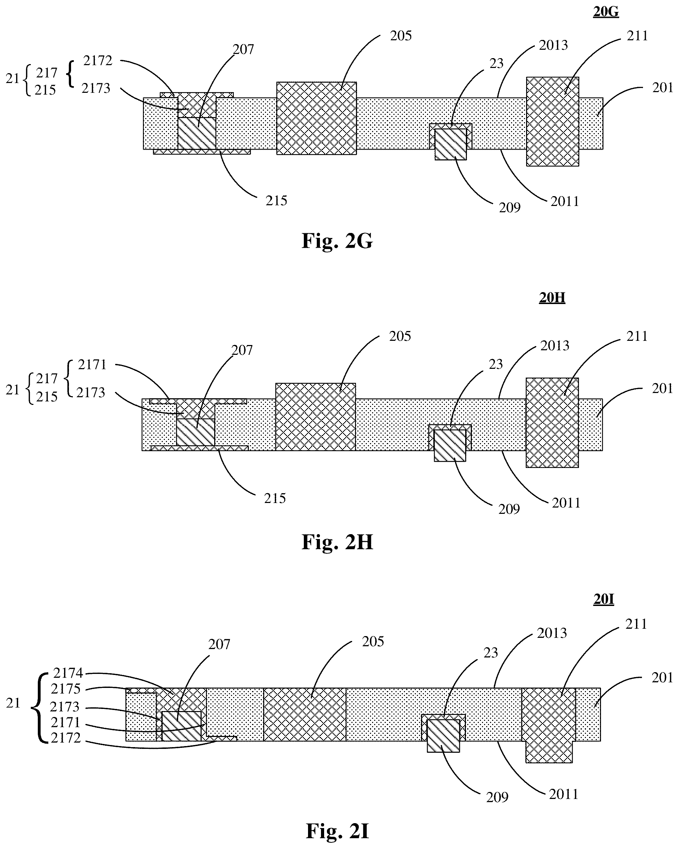

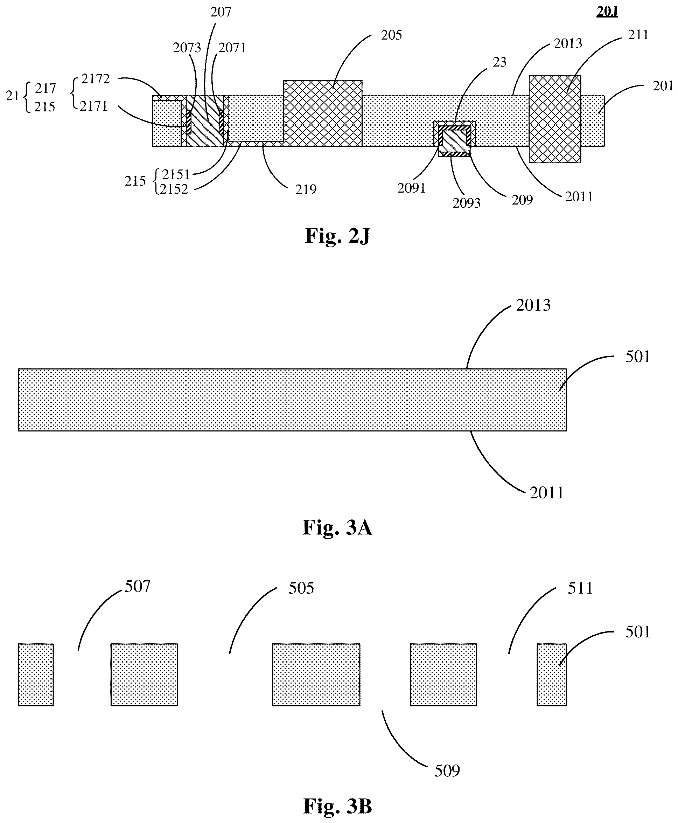

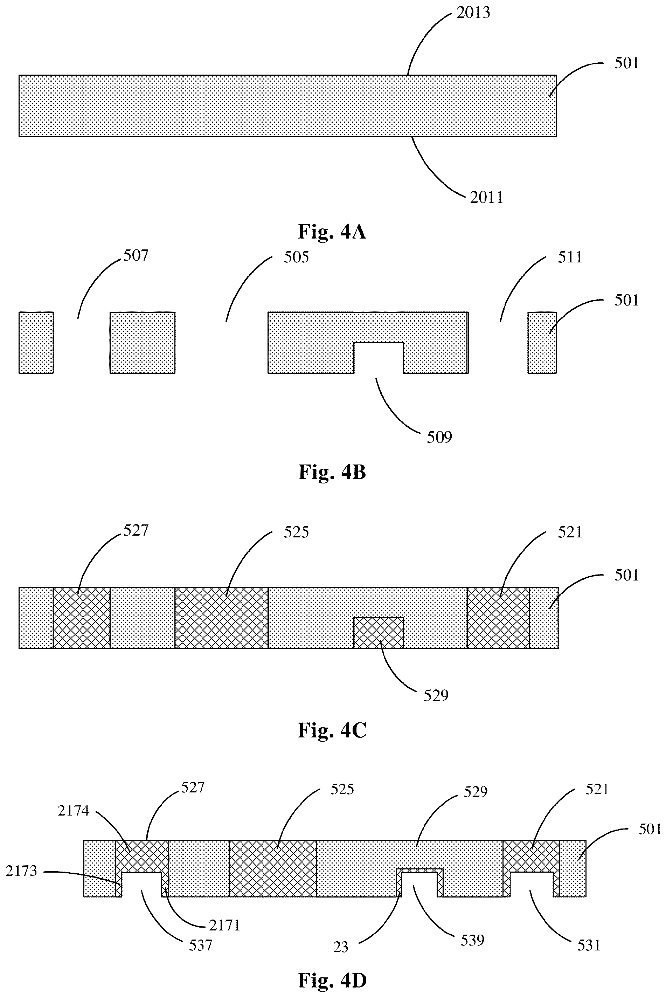

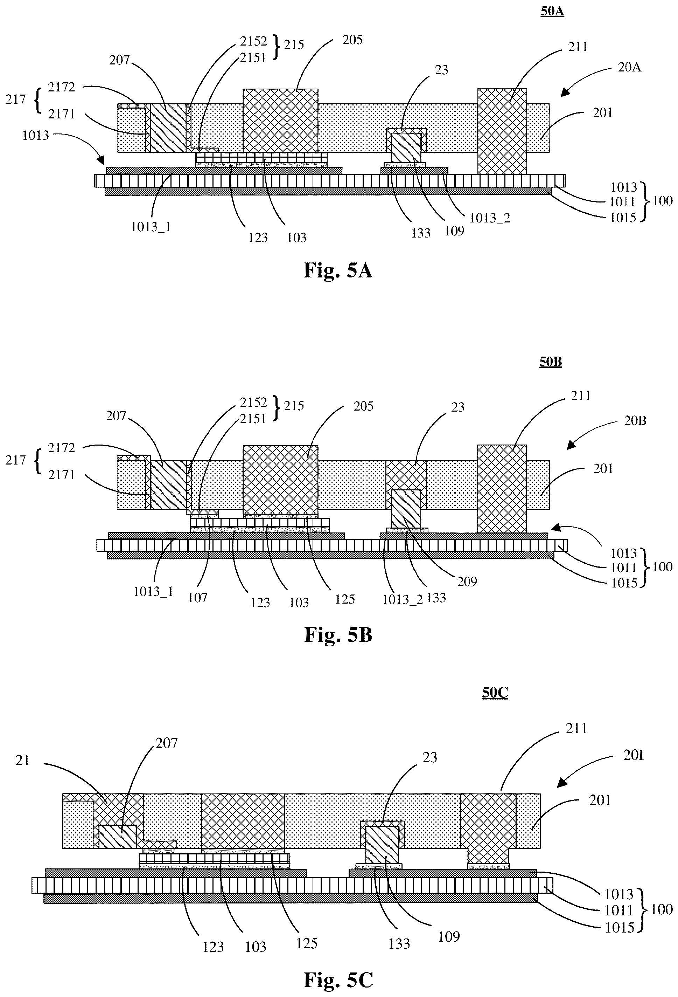

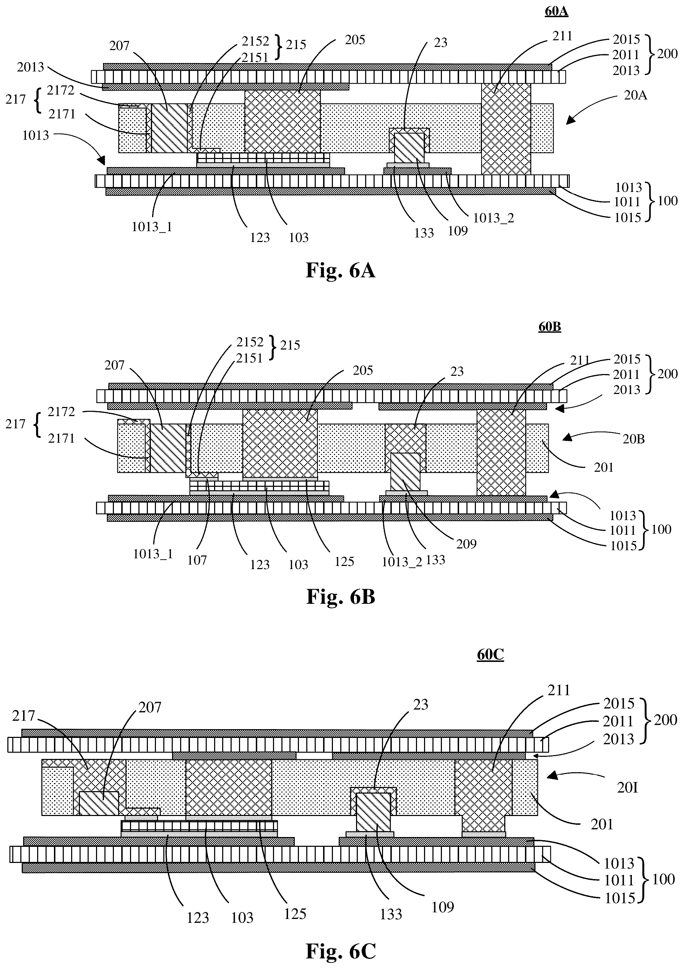

FIG. 2A shows an interposer substrate 20A for package structure. As shown in FIG. 2A, the interposer substrate 20A may include an insulating body 201 having one or more holes (not labeled in FIG. 2A; c.f., *e.g.,* FIGS. 3B and 4B). The insulating body 201 may be formed of an insulating material, for example, a ceramic or organic insulating material such as epoxy, polyimide, or the like. The organic insulating material may contain, for example, glass fiber or the like. The interposer substrate 20A may further include one or more coupling members (*e.g.,* coupling members 21, 23) provided on and/or in the insulating body. The coupling members 21, 23 may be formed of a metal, such as but not limited to, copper. The interposer substrate 20A may further include one or more electronic components, such as electronic components 207, 209. The one or more electronic components may include a first electronic component, such as the component 207 or 209. Taking the component 207 as an example of the first electronic component, the component 207 may be provided in a first hole (not labeled in FIG. 2; c.f., *e.g.,* 507 in FIG. 3B) of the one or more holes, electrically coupled to a corresponding first coupling member 21 of the one or more coupling members (*e.g.,* a first conductor portion 215 thereof), and adapted to be electrically coupled to other members of the package structure external to the interposer substrate 20A through the first coupling member 21, as will be described below with reference to FIGS. 5A-5C and 6A-6C. By way of example, the component 207 may be, for example but not limited to, a gate resistor adapted to be electrically coupled to a gate electrode of a die through the first coupling member (*e.g.,* via a portion thereof).

According to an embodiment of the present disclosure, a first hole (c.f., *e.g.,* 507 in FIG. 3B) extends through the insulating body 201 from a first face (*e.g.,* lower surface 2011) of the insulating body 201 to a second face *(e.g.,* upper surface 2013) of the insulating body 201 opposite to the first face. The first coupling member 21 may be formed of metal (*e.g.,* copper, or the like). The first coupling member 21 may include a first conductor portion 215 provided on or in the first face of the insulating body 201. In some embodiments, as shown in FIG. 2A, the first conductor portion 215 may include a first portion 2151 at a sidewall of the first hole. The first portion 2151 may be electrically connected to an electrode 2071 of the first component 207. The first conductor portion 215 may further include a second portion 2152 on or in the first face of the insulating body 201. The second portion 2152 is configured to extend along, or substantially parallel to, the first face of the insulating body 201. In FIG. 2A, the second portion 2152 is shown as being provided in the insulating body 201, more specifically, in the first face of the insulating body 201. The second portion 2152 may be configured to be electrically coupled to a component (*e.g.,* die or mounting substrate, etc.) external to the interposer substrate.

The first coupling member 21 may further include a second conductor portion 217. As shown in FIG. 2A, the second conductor portion 217 may include a first portion 2171 at a sidewall of the first hole. The first portion 2171 may be electrically connected to another electrode 2073 of the first component 207. The second conductor portion 217 may further include a second portion 2172 on or in the second face 2013 of the insulating body 201. The second portion 2172 is configured to extend along, or substantially parallel to, the second face 2013 of the insulating body 201. In FIG. 2A, the second portion 2172 is shown as being disposed in the insulating body 201, more specifically, in the second face (upper surface) 2013 of the insulating body 201, with the upper surface of the second portion 2172 being substantially flush with the second face 2013. The second portion 2172 may be configured to be electrically coupled to an external component (*e.g.,* die, mounting substrate, or other circuit component(s)). It should also be understood that the configurations of electrodes of the components (*e.g.,* first component 207) shown herein are merely exemplary, and there may be a variety of electrode configurations as desired.

The one or more electronic components may further include additional electronic components (second electronic component) such as, but not limited to, component 209. The second electronic component may be provided in a second hole (not labeled in FIG. 2A; c.f., *e.g.,* 509 in FIG. 4B) of the one or more holes. In this example, the second hole is a blind hole (also referred to as recess), that is, it does not penetrate through the insulating body 201. The second electronic component may be electrically coupled to a corresponding second coupling member (*e.g.,* coupling member 23) of the one or more coupling members, and is adapted to be electrically coupled, *e.g.,* through the corresponding second coupling member, to a component external to the interposer substrate, such as to a component bonding portion of the first mounting substrate, as will be described below with reference to FIGS. 5A-5C and 6A-6C.

As shown in FIG. 2A (and FIG. 4B), the second hole extends inward from the first face of the insulating body 201 and does not extend to the second face of the insulating body opposite to the first face. The second coupling member 23 covers a surface of the second hole (which may include its bottom surface and side surface(s)), and the second coupling member 23 has a recess (c.f., 539 in FIG. 4D) extending inward from the first face 2011 of the insulating body 201/501. The component 209 may be disposed at least partially in the recess 539, and the second coupling member 23 is electrically coupled to the component 209, *e.g.,* to an electrode thereof. By way of example, the component 209 may be, for example, but not limited to, a temperature sensing element, such as an NTC thermistor. In FIG. 2A, the component 209 is exemplarily shown as including electrodes 2091 and 2093. The electrode 2091 is configured to be electrically coupled to the conductive member 23, while the electrode 2093 is configured to be electrically coupled to other members. In the context of the present disclosure, when reference is made to A being electrically coupled to B, it may include A being in direct contact with B or A being electrically coupled to B through an intermediate member or conductive material therebetween.

It should be understood that, although in certain embodiments the components 207 and 209 and corresponding holes and coupling members are shown and described as being distinct from one another, it will be appreciated by those skilled in the art that is the contents described in connection with the configurations of the components 207 and 209 and the corresponding holes and coupling members, etc., may be applied interchangeably where appropriate. For example, in FIG. 2A, the component 207 may also serve as the component 209, and the component 209 may serve as the component 207.

The interposer substrate 20A may further include a conductive spacer 205. The spacer 205 may be disposed in a third hole (not labeled in FIG. 2A; c.f., *e.g.,* 505 in FIG. 3B) of the one or more holes. In some embodiments, the spacer 205 may be configured to be electrically coupled to an electrode of a die, for example. The spacer 205 may be formed of a conductive material, for example, a metal such as copper. In the example shown in FIG. 2A, the spacer 205 is shown as its lower surface substantially flush with a lower surface of the second portion 2152 of the first conductor portion 215, *i.e.,* substantially flush with the lower surface 2011 of the insulating body 201.

The interposer substrate 20A may further include a support or pillar 211. The pillar 211 may be disposed in a fourth hole (not labeled in FIG. 2A; c.f., *e.g.,* 511 of FIG. 3B) of the one or more holes. In some embodiments, the pillar 211 is configured to be bonded to the first and second mounting substrates with two ends thereof, respectively. Similar to the spacer 205, the pillar 211 may be formed of a conductive material, for example, a metal such as copper. A portion of the first conductor portion 215 or the second portion 217 that extends along the surface of the insulating body 201 may represent, for example but not limited to, wiring(s) for electrical connection.

FIG. 2B shows an interposer substrate 20B for the package structure. The interposer substrate 20B differs from the interposer substrate 20A shown in FIG. 2A mainly in the following aspects. In the interposer substrate 20B, the second hole for the component 209 is a through hole penetrating through the insulating body 201, and accordingly the configuration of the second coupling member 23 is different from that of the second coupling member 23 in the example of FIG. 2A. In the interposer substrate 20B, the second portion 2152 of the first conductor portion 215 is configured to protrude from the first face 2011 of the insulating body 201, or in other words, over the first face of the insulating body 201 (relative to the first face of the insulating body). In the orientation shown in FIG. 2A, the second portion 2152 is shown as being below the first face (lower surface) of the insulating body 201. Further, in the interposer substrate 20B, the second portion 2172 of the second conductor portion 217 is disposed protruding from the second face 2013 of the insulating body 201, or in other words, over the second face 2013 of the insulating body 201 (relative to the second face of the insulating body). In the orientation shown in FIG. 2A, the second portion 2172 is shown as being above the second face (upper surface) 2013 of the insulating body 201.

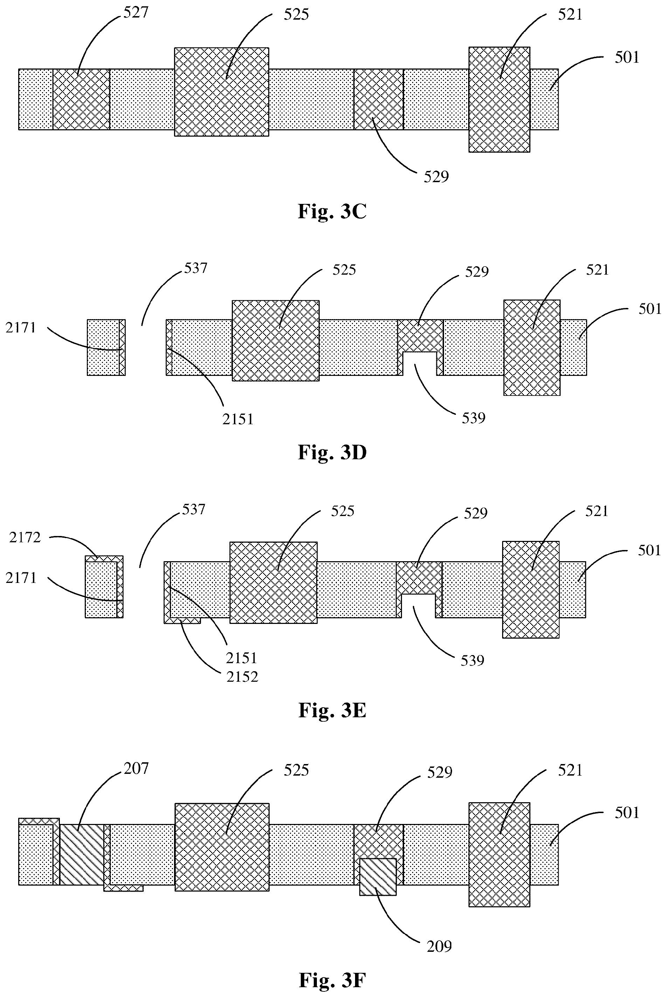

As shown in FIG. 2B (and FIG. 3B), the second hole 509 (c.f. FIG. 3B) extends through the insulating body 201 from the first face 2011 of the insulating body 201 to the second face 2013 of the insulating body 201 opposite to the first face 2011. The second coupling member 23 is filled in the second hole 509 and extends from the second face 2013 of the insulating body 201 towards the first face 2011 of the insulating body 201. In the example shown in FIG. 2B, the second coupling member 23 extends from the second face 2013 of the insulating body 201 to the first face 2011; however, the present disclosure is not limited thereto. In the example shown in FIG. 2B, the second coupling member 23 has a recess 539 (c.f. FIG. 3D) that extends inward from the first face of the insulating body 201. The second component 209 is at least partially disposed in the recess 539 and is electrically coupled to the second coupling member 513. Note that an exemplary configuration of an electrode of the component 209 is shown in FIG. 2B, but the electrode of the component 207 is omitted from being illustrated. As shown in FIG. 2B, the component 209 has electrodes 2091 and 2093 disposed at its upper and lower ends, respectively, where the electrode 2091 is electrically coupled to the coupling member 23.

Further, in the example interposer substrate 20B shown in FIG. 2B, the spacer 205 is shown as its lower surface protruding from the lower surface 2011 of the insulating body 201, and being substantially flush with the lower surface of the second portion 2152 of the first conductor portion 215.

The above descriptions with respect to FIG. 2A can be applied likewise or adaptively herein and therefore is not repeated here.

FIG. 2C shows an interposer substrate 20C for the package structure. The interposer substrate 20C differs from the interposer substrate 20A shown in FIG. 2A mainly in the following aspects. In the interposer substrate 20C, the coupling member 23 and the component 209 shown in FIG. 2B are incorporated. In addition, in the interposer substrate 20C, the first conductor portion 215 of the first coupling member 21 does not have the first portion 2151 at the sidewall of the corresponding hole, which means that only the second portion 2152 in FIG. 2A is retained. Likewise, the second conductor portion 217 does not have the first portion 2171 at the sidewall of the corresponding hole, which means that only the second portion 2172 in FIG. 2A is retained. In the example of FIG. 2C, the first conductor portion 215 (2152) and the second conductor portion 217 (2172) are electrically coupled to the component 207 at the sidewalls of the holes, respectively, *e*.*g*., electrically connected to or in contact with electrodes 2071 and 2073 of the component 207. In this example, the spacer 205 is also shown as its lower surface is substantially flush with the lower surface of the first conductor portion 215, *i.e.,* substantially flush with the lower surface 2011 of the insulating body 201. Those contents described above with respect to the preceding figures can be likewise or adaptively applied herein and therefore will not be repeated.

FIG. 2D shows an interposer substrate 20D for the package structure. The interposer substrate 20D differs from the interposer substrate 20C shown in FIG. 2C mainly in the following aspects. In the interposer substrate 20D, the first conductor portion 215 extends along the first surface 2011 of the insulating body 201, covering at least a portion of an open end of the corresponding first hole, and is thereby electrically coupled to one end of the component 207 (here, its lower end), forming an electrical connection with the electrode 2071 of the component 207. Likewise, the second conductor portion 217 extends along the second surface 2013 of the insulating body 201, covering at least a portion of the open end of the corresponding first hole, and is thereby electrically coupled to the other end of the component 207 (here, its upper end), forming an electrical connection with the electrode 2073 of the component 207. In this example, the spacer 205 is also shown as its lower surface is substantially flush with the lower surface of the first conductor portion 215, *i.e.,* substantially flush with the lower surface 2011 of the insulating body 201. In addition, in the interposer substrate 20D, the arrangement of the second component 209 and the second coupling member 23 and the corresponding holes as well is the same as that shown in FIG. 2A. Those contents described above with respect to the preceding figures can be likewise or adaptively applied herein and therefore will not be repeated.

FIG. 2E shows an interposer substrate 20E for the package structure. The interposer substrate 20E differs from the interposer substrate 20D shown in FIG. 2D mainly in the following aspects. In the interposer substrate 20E, the first conductor portion 215 is formed protruding from the first face 2011 of the insulating body 201, and the second conductor portion 217 is formed protruding from the second face 2013 of the insulating body 201. As shown in FIG. 2E, the first conductor portion 215 extends along the first face 2011 of the insulating body 201, covering at least a portion of an open end of the corresponding first hole, and is thereby electrically connected to or in contact with one end of the component 207 (here, its lower end), forming an electrical connection with an electrode (not shown in FIG. 2E) of the component 207. Likewise, the second conductor portion 217 extends along the second face 2013 of the insulating body 201, covering at least a portion of the open end of the corresponding first hole, and is thereby electrically connected to or in contact with the other end of the component 207 (here, its upper end), forming an electrical connection with an electrode (not shown in FIG. 2E) of the component 207. In this example, the spacer 205 is also shown with its lower surface substantially flush with the lower surface of the first conductor portion 215. Those described above with respect to the preceding figures can be likewise or adaptively applied herein and therefore will not be repeated.

FIG. 2F shows an interposer substrate 20F for the package structure. The interposer substrate 20F differs from the interposer substrate 20A shown in FIG. 2A mainly in the configuration of the first coupling member 21 and the corresponding holes. As shown in FIG. 2F, in the interposer substrate 20F, the first coupling member 21 may include first to fifth conductor portions 2171-2175. The first conductor portion 2171 is disposed at the sidewall of the corresponding first hole. The second conductor portion 2172 may be disposed on or in the first face 2011 of the insulating body 201. The second conductor portion 2172 is disposed extending along or substantially parallel to the first face 2011 of the insulating body 201. In FIG. 2F, the second conductor portion 2172 is shown as being disposed in the insulating body 201, more specifically, in the first face 2011 of the insulating body 201, and its lower surface is substantially flush with the first face 2011. The second conductor portion 2172 may be configured to be electrically coupled to an external component (e.g., die or mounting substrate, etc.). Optionally, the third conductor portion 2173 may be disposed at opposite sidewalls of the first hole. The fourth conductor portion 2174 may be disposed on or in the first face 2011 of the insulating body 201. The fourth conductor portion 2174 is disposed extending along or substantially parallel to the first face 2011 of the insulating body 201. In FIG. 2F, the optional fourth conductor portion 2174 is shown as being disposed in the insulating body 201, more specifically, in the first face (lower surface) 2011 of the insulating body 201, with its lower surface substantially flush with the first face. The fifth conductor portion 2175 is disposed to be coupled to or integrally formed with the first conductor portion 2171 and the third conductor portion 2173, and covers an opening of the first hole from a side of the second face (upper surface 2013) of the insulating body 201. The fifth conductor portion 2175 may be disposed on and/or in the second face 2013 of the insulating body 201 and may be disposed extending along or substantially parallel to the second face 2013 of the insulating body 201. In FIG. 2F, the fifth conductor portion 2175 is shown as it may include a portion disposed in the insulating body 201 and a portion protruding from the insulating body 201; however, the present disclosure is not limited thereto. Additionally, the fifth conductor portion 2175 is shown as protruding laterally from the corresponding hole; however, the present disclosure is not limited thereto. One or more of the first conductor portion 2171, the fifth conductor portion 2175, and the third conductor portion 2173 may be electrically connected to an electrode (not shown) of the first component 207. It will be appreciated that other electrodes of the first component 207 may be disposed at a position offset from the cross-section illustrated in FIG. 2F. The contents described above with respect to the preceding figures can be likewise or adaptively applied herein and therefore will not be repeated.

FIG. 2G shows an interposer substrate 20G for the package structure. The interposer substrate 20G differs from the interposer substrate 20E shown in FIG. 2E mainly in the configuration of the first coupling member 21 and the corresponding holes. As shown in FIG. 2G, the first coupling member 21 may include a first conductor portion 215 and a second conductor portion 217. In the interposer substrate 20G, the first conductor portion 215 is formed protruding from the first face 2011 of the insulating body 201. The first conductor portion 215 extends along the first face 2011 of the insulating body 201, covering at least a portion of an open end of the corresponding first hole, and is thereby electrically coupled to one end of the component 207 (here, its lower end), forming an electrical connection with an electrode (not shown in FIG. 2G) of the component 207. The second conductor portion 217 is formed as including a first portion 2172 protruding from the second face 2013 of the insulating body 201 and a second portion 2173 embedded in a corresponding hole. The first portion 2172 of the second conductor portion 217 extends along the second face 2013 of the insulating body 201, covering at least a portion of the open end of the corresponding first hole, meanwhile the second portion 2173 of the second conductor portion 217 is electrically coupled to the other end of the component 207 (here, its upper end), forming an electrical connection with an electrode (not shown in FIG. 2G) of the component 207. In this example, the spacer 205 is also shown as its lower surface is substantially flush with the lower surface of the first conductor portion 215. Those described above with respect to the preceding figures can be likewise or adaptively applied herein and therefore will not be repeated.

Fig. 2H shows an interposer substrate 20H for the package structure. The interposer substrate 20H differs from the interposer substrate 20E shown in FIG. 2E mainly in the configuration of the first coupling member 21 and the corresponding holes. As shown in FIG. 2H, the first coupling member 21 may include a first conductor portion 215 and a second conductor portion 217. In the interposer substrate 20H, the first conductor portion 215 is formed in the first face 2011 of the insulating body 201, with its lower surface substantially flush with the first face 2011. The first conductor portion 215 extends along the first face 2011 of insulating body 201, covering at least a portion of the open end of the corresponding first hole, and is thereby electrically coupled to an end of the component 207 (here, its lower end), forming an electrical connection with an electrode (not shown in FIG. 2H) of the component 207. The second conductor portion 217 is formed to include a first portion 2171 protruding laterally from a sidewall of a corresponding hole, and a second portion 2172 embedded in a corresponding hole. The first portion 2171 of the second conductor portion 217 extends along the second face 2013 of the insulating body 201, covering at least a portion of the open end of the corresponding first hole, while the second portion 2172 of the second conductor portion 217 is electrically coupled to the other end of the component 207 (here, its upper end), forming an electrical connection with an electrode (not shown) of the component 207. Although the first portion 2171 of the second conductor portion 217 is shown as including a portion protruding laterally from the sidewall of the corresponding hole, the present disclosure is not limited thereto. In other implementations, the first portion 2171 may have no such a portion protruding laterally from the side wall of the hole. Those described above with respect to the preceding figures can be likewise or adaptively applied herein and therefore will not be repeated.

FIG. 2I shows an interposer substrate 20I for the package structure. In the interposer substrate 20I, the first coupling member 21 is similar to the first coupling member 21 shown in FIG. 2F to some extent. As shown in FIG. 2I, the first coupling member 21 may include first to fifth conductor portions 2171 and 2175. The first conductor portion 2171 is disposed at a sidewall of the corresponding first hole. The second conductor portion 2172 may be disposed on or in the first face 2011 of the insulating body 201. The second conductor portion 2172 is disposed extending along or substantially parallel to the first face 2011 of the insulating body 201. In FIG. 2I, the second conductor portion 2172 is shown as being disposed in the insulating body 201, more specifically, in the first face 2011 of the insulating body 201, with its lower surface substantially flush with the first face 2011 of the insulating body 201. The second conductor portion 2172 may be configured to be electrically coupled to an external component (e.g., die or mounting substrate, etc.). Optionally, the third conductor portion 2173 may be disposed at opposite sidewalls of the first hole. The fourth conductor portion 2174 is configured to be filled in a corresponding hole, coupled to or integrally formed with the first conductor portion 2171 and the third conductor portion 2173, and cover the opening of the first hole from the second face 2013 of the insulating body 201. The fifth conductor portion 2175 is coupled to or integrally formed with the fourth conductor portion 2174, may be disposed on or in the second face 2013 of the insulating body 201, and may be disposed extending along or substantially parallel to the second face 2013 of the insulating body 201. As shown, the fourth conductor portion 2174 and the fifth conductor portion 2175 may be disposed such that their upper surfaces are substantially flush with the second face 2013 of the insulating body 201. As an example, the fourth conductor portion 2174 may represent wiring for electrical connection. One or more of the first conductor portion 2171, the fifth conductor portion 2175, and the third conductor portion 2173 may be electrically connected to an electrode (not shown) of the first component 207. It will be appreciated that other electrodes of the first component 207 may be disposed at a position offset from the cross-section shown in FIG. 2I.

Further, in the interposer substrate 20I, as shown in FIG. 2I, the spacer 205 is disposed with its lower surface substantially flush with the lower surface 2011 of the insulating body 201, and its upper surface substantially flush with the upper surface 2013 of the insulating body 201.

In the interposer substrate 20I, the pillar 211 may be disposed with its upper surface substantially flush with the upper surface 2013 of the insulating body 201. A portion of the pillar 211 protruding from the lower surface 2011 of the insulating body 201 may have a lateral dimension less than that of a portion of the pillar 211 embedded in the insulating body 201. It will be appreciated that the contents described above with respect to the preceding figures can be likewise or adaptively applied herein and therefore will not be repeated.

FIG. 2J shows an interposer substrate 20J for the package structure. The interposer substrate 20J differs from the interposer substrate 20A shown in FIG. 2A mainly in that, the first conductor portion 215 of the first coupling member 21 thereof is coupled to the spacer 205 via the conductor portion 219, or they can be integrally formed. Specifically, the second portion 2152 of the first conductor portion 215 is electrically coupled to the spacer 205 along the lower surface 2011 of the insulating body 201. It should be understood that the wiring on the interposer substrate can be varied. For example, additional wiring or other coupling members can be disposed as needed to connect the various components, members, or conductors, etc. of the interposer substrate. Those contents described above with respect to the preceding figures can be likewise or adaptively applied herein and therefore will not be repeated.

FIGS. 3A-3F show schematic cross-sectional views for illustrating the steps of a manufacturing method of an interposer substrate according to some embodiments of the present disclosure. What is described above with respect to the preceding figures can be likewise or adaptively applied herein and therefore will not be repeated.

As shown in FIG. 3A, an insulating body 501 is provided. The insulating body 501 may be formed of a ceramic or organic insulating material. The insulating body 501 may have a first face 2011 and a second face 2013.

As shown in FIG. 3B, one or more holes 507, 509 are formed in the insulating body 501. Optionally, one or more holes 505, 511 may additionally be formed in the insulating body 501. It should be understood that although in the implementation shown in FIG. 3B, holes 507, 509 and holes 505, 511 are shown as being formed in the same step, the present disclosure is not limited thereto. There is no limitation on the geometry or size of the holes, which may be configured according to the applications thereof. In addition, although in FIG. 3B, the cross-sections of the holes are shown to be substantially the same in their lateral dimensions, the present disclosure is not limited thereto; for example, in some embodiments, a portion of the holes may be made to have a different lateral dimension than another portion. It should also be understood that although in the embodiment shown in FIG. 3B, the holes are shown as through holes that penetrate through the insulating substrate 201, the present disclosure is not limited thereto. For example, in other embodiments, the holes may be non-through holes (also referred to as blind holes), *i.e.,* not penetrating through the layer in which they are located (*e.g.,* insulating body 501/201). Thus, in the context of this disclosure, the term "hole" is intended to include both through-hole and blind hole (which may also be referred to as recess).

Next, one or more coupling members are formed on or in the insulating body. This will be described below with reference to FIGS. 3C-3E.

In some implementations, as shown in FIG. 3C, fillers 527 and 529 formed of electrically conductive material (*e.g.,* a metal such as copper) may be formed in holes 507 and 509, respectively. The conductive fillers 527 and 529 may be formed by, for example, a plating process, a sintering process, and/or a damascene process. For example, a copper layer may be plated on a surface of the insulating body 501 (the surface containing holes therein) by the plating process (e.g., electroplating or electroless plating) to fill at least the holes 507 and 509. Thereafter, undesired portions of the plated copper layer may be removed to form the conductive fillers 527 and 529. Alternatively, a thin liner layer (*e.g.,* a plating layer) may be formed on the surface of the hole of the insulating body 501, a suitably shaped metal member may be inserted into the hole, and after that, a firm bond between the metal member and the liner layer may be formed by a thermal melting or sintering process, thus forming the conductive fillers 527 and 529.

Optionally, in this step, filler 525 for a spacer and filler 521 for a pillar may also be formed in the holes 505 and 511 in a similar manner. In other implementations, the conductive fillers 525 and 521 may be formed in a different step than the conductive fillers 527 and 529.

Thereafter, as shown in FIG. 3D, a portion of the conductive fillers 527 and 529 is removed, for example, by an etching or drilling process. In the implementation shown in FIG. 3D, a through hole 537 is formed in the conductive filler 527, thereby forming a layer of conductive material on a sidewall of the hole 507, which may serve as, for example, parts of the first and second conductor portions 215 and 217 as shown in FIGS. 2A, 2B, etc., such as the first portions 2151 and 2171. And a blind hole (or recess) 539 is formed in the conductive filler 529 so as to form, for example, the second coupling member 23 as shown in FIG. 2C etc. In this case, the conductive filler 529 may serve as, for example, the second coupling member 23 as shown in FIGS. 2B and 2C.

Thereafter, as shown in FIG. 3E, a conductive layer is formed on or in a surface of the insulating body 501. Conductive layers 2152 and 2172, which are respectively on the first side 2011 and the second side 2013 of the insulating body 501, are formed, for example, by plating and etching processes. For example, in some implementations, a plating layer may be formed on the structure as shown in FIG. 3D by a plating process, then undesired portions of the plating layer may be selectively removed, thus obtaining the structure shown in FIG. 3E. It should also be understood that although FIG. 3E shows that portions 2152 and 2172 of the plating layer are retained, in other embodiments, additional portions of the plating layer may be retained, such as portions formed on the fillers 521, 525, or other portions formed on the insulating body 501 (*e.g.,* as connection conductors or wires, which may be similar to, for example, the connection conductor 219 of FIG. 2J), if desired.

Thereafter, one or more electronic components may be provided. As shown in FIG. 3F, component 207 is disposed in the hole 537 and component 209 is disposed in the hole 539 (which is in the conductive filler 529). Components 207 and 209 may be the components 207 and 209 as described above in connection with the preceding figures. Components 207 and 209 may be electrically coupled to corresponding coupling members, respectively.

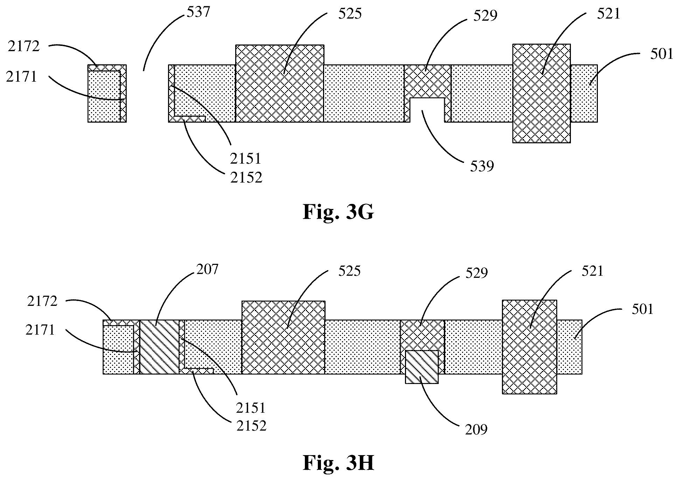

FIGS. 3G and 3H show schematic cross-sectional views of part of alternative steps of a manufacturing method of an interposer substrate according to an alternative embodiment, which replace the steps of FIGS. 3E and 3F described previously. Note that in the preceding FIG. 3C, spacer 205 is disposed protruding from a lower surface 2011 of the insulating body 501 so that the lower surface of spacer 205 is substantially flush with a lower surface of the second portion 2152 of the first conductor portion 215 in FIG. 3E. In this alternative implementation, a lower surface of the spacer 205 is formed to be substantially flush with the lower surface 2011 of the insulating body 501. Also in this alternative implementation, in the step shown in FIG. 3G, the second portion 2152 of the first conductor portion 215 is formed in the lower surface 2011 of insulating body 201, and the lower surface of the second portion 2152 is substantially flush with the lower surface 2011 of the insulating body 201. Further, as shown in FIG. 3G, the second portion 2172 of the second conductor portion 217 is formed in the upper surface 2013 of the insulating body 201, and the upper surface of the second portion 2172 is substantially flush with the upper surface 2013 of the insulating body 201. Thereafter, one or more electronic components may be provided. As shown in FIG. 3H, component 207 is disposed in the hole 537 and component 209 is disposed in the hole 539 (which is in the conductive fillers 529). Components 207 and 209 may be electrically coupled to corresponding coupling members, respectively.

FIGS. 4A-4F show schematic cross-sectional views illustrating the steps of a manufacturing method of an interposer substrate according to further embodiments of the present disclosure. Those contents described above with respect to FIGS. 3A-3H can be likewise or adaptively applied to the embodiments described with respect to FIGS. 4A-4F.

As shown in FIG. 4A, an insulating body 501 is provided. The insulating body 501 may be formed of ceramic material or organic insulating material, etc. The insulating body 501 may have a first face 2011 and a second face 2013.

Next, one or more holes may be formed in the insulating body. As shown in FIG. 4B, one or more holes 507, 509 are formed in the insulating body 501. Optionally, one or more holes 505, 511 may further be formed in the insulating body 501. In the embodiment shown in FIG. 4B, holes 505, 507, and 511 are shown as through holes that penetrate an insulating substrate 201, while hole 509 is shown as a blind hole (which may also be referred to as a recess). Similarly, it should be understood that although in the implementation shown in FIG. 4B, holes 507, 509 and holes 505, 511 are shown as being formed in the same step, the present disclosure is not limited thereto. There is no limitation on the geometry or size of the holes, which may be configured as required according to the application.

Then, one or more coupling members are formed on or in the insulating body. This will be explained below with reference to FIGS. 4C to 4E.

In some implementations, as shown in FIG. 4C, fillers 527 and 529 of electrically conductive material (*e.g.,* a metal such as copper) may be formed in holes 507 and 509, respectively. The conductive fillers 527 and 529 may be formed by, for example, a plating process, a sintering process, and/or a damascene process. For example, a copper layer may be plated on a surface of the insulating body 501 (the surface having holes therein) by the plating process (*e.g.,* electroplating or electroless plating) to fill at least holes 507 and 509. Thereafter, undesired portions of the plated copper layer may be removed to form the conductive fillers 527 and 529. Alternatively, a thin liner layer (*e.g.,* a metal (*e.g.,* copper) plating layer) may be formed on the surface of a hole of the insulating body 501, a suitably shaped metal member (*e.g.,* formed of copper) may be inserted into the hole, and after that, a firm bond between the metal member and the liner layer may be formed by a thermal melting or sintering process, thus forming the conductive fillers 527 and 529.

Optionally, in this step, filler 525 for a spacer and filler 521 for a pillar may also be formed in the holes 505 and 511 in a similar manner. In other implementations, the conductive fillers 525 and 521 may be formed in a different step than the conductive fillers 527 and 529. Here, the fillers 521, 525, 527 are formed to have a thickness substantially the same as that of the insulating body 501, and their respective upper and lower surfaces are substantially flush with the upper surface 2013 and the lower surface 2011 of the insulating body 501.

Thereafter, as shown in FIG. 4D, a portion of the conductive fillers 527 and 529 is removed, for example, by an etching or drilling process. In the implementation shown in FIG. 4D, a blind hole 537 is formed in the conductive filler 527, thereby forming a layer of conductive material on the sidewall of the hole 507, which may correspond to the portions 2171 and 2173 shown in FIG. 2I. And a blind hole (or recess) 539 is formed in the conductive filler 529 so as to form a second coupling member 23 as shown in FIG. 2I, etc., for example. In the present embodiment, a portion of the conductive filler 521 is further removed, where a blind hole 531 is formed.

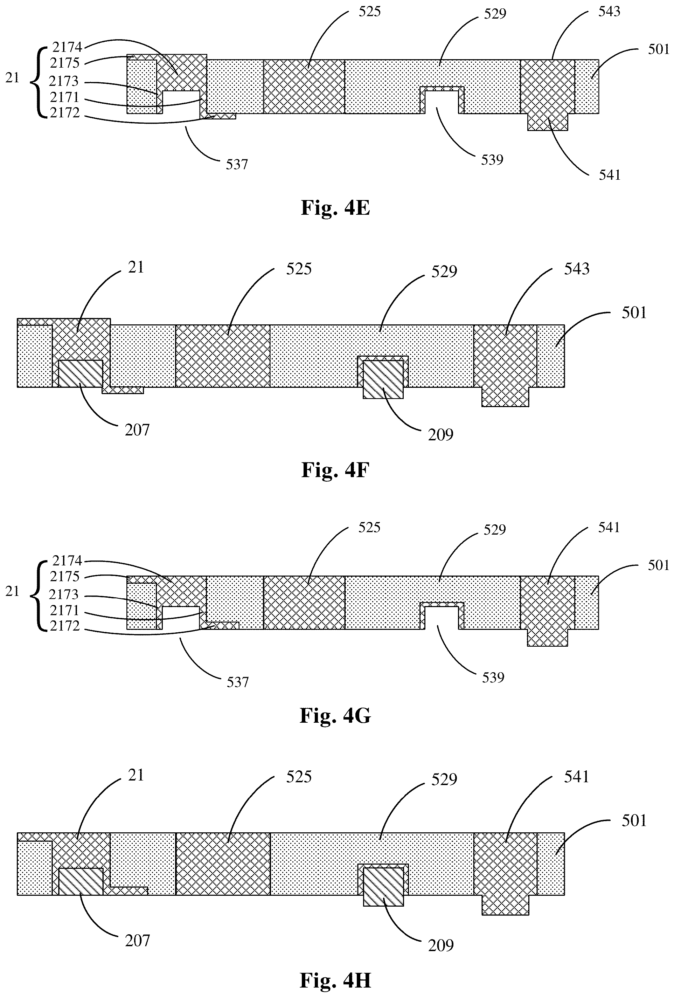

Thereafter, as shown in FIG. 4E, a conductive layer is formed on or in the surface of the insulating body 501. Conductive layers 2175 and 2172 are formed on a first face 2011 and a second face 2013 of the insulating body 501, respectively, for example, by electroplating and etching processes. For example, similarly, a plated layer may be formed on the structure shown in FIG. 3D by a plating process, after which undesired portions of the plated layer may be selectively removed, thus obtaining the structure shown in FIG. 3E. It should also be understood that in other embodiments, additional portions of the plating layer may be retained, if desired.

In the present embodiment, a conductive member 541 filled in a blind hole 531 of the conductive filler 521 is further formed. As shown in FIG. 4E, the conductive member 541 extends protruding from the lower surface 2011 of the insulating body 501. The conductive member 541 may be bonded to the conductive filler 521 having the blind hole 531, together forming the pillar 211.

Thereafter, one or more electronic components may be provided. As shown in FIG. 4F, component 207 is disposed in the hole 537 (which is in the hole 507) and component 209 is disposed in the hole 539 (which is in the hole 509). Such components 207 and 209 may be the components 207 and 209 as described above in connection with preceding figures. Components 207 and 209 may be electrically coupled to corresponding coupling members, respectively.

FIGS. 4G and 4H show schematic cross-sectional views illustrating part of alternative steps of a manufacturing method of an interposer substrate according to an alternative embodiment, which replace the steps of FIGS. 4E and 4F described previously. In this alternative implementation, the lower surface of the spacer 205 is formed to be substantially flush with the lower surface 2011 of the insulating body 501. Also in this alternative implementation, in the step shown in FIG. 4G, the second conductor portion 2172 of the coupling member 21 is formed in the lower surface 2011 of the insulating body 201, and the lower surface of the second portion 2172 is substantially flush with the lower surface 2011 of the insulating body 201. Further, as shown in FIG. 4G, a fifth conductor portion 2175 is formed in the upper surface 2013 of the insulating body 201, and the upper surface of the fifth portion 2175 is substantially flush with the upper surface 2013 of the insulating body 201.

Thereafter, one or more electronic components may be provided. As shown in FIG. 4H, the component 207 is disposed in the hole 537 (which is in the hole 507) and the component 209 is disposed in the hole 539 (which is in the hole 509). Components 207 and 209 may be electrically coupled to corresponding coupling members, respectively.

FIGS. 5A, 5B, and 5C respectively show schematic cross-sectional views of package structures according to some embodiments of the present disclosure. According to various embodiments, the package structure may be a power module or a part thereof, or may be an intermediate structure for preparing a power module.

As shown in FIG. 5A, a package structure 50A may include a mounting substrate and an interposer substrate. The interposer substrate may be the interposer substrate according to any of the embodiments. In FIG. 5A, as an example, an interposer substrate 20A as shown in FIG. 2A and a first mounting substrate 100 are shown. Note that the electrodes of components 207 and 209 are not shown in FIG. 5A. The first mounting substrate 100 may include an insulating body 1011 and conductive layers 1013 and 1015 on both sides thereof. In some embodiments, the conductive layer 1013 may have a plurality of portions, such as a die bonding portion 1013_1 for attaching a die, a component bonding portion 1013_2 for attaching other components, etc. It should be understood that although the die bonding portion 1013_1 and the component bonding portion 1013_2 are shown here as separate components, the present disclosure is not limited thereto.

The mounting substrate 100 may be mounted with a power die 103. The power die 103 is electrically coupled to the die bonding portion 1013_1 of the mounting substrate 100, for example, through a conductive bonding material 123. The die 103 is disposed between the interposer substrate 20A and the first mounting substrate 100. The component 207 is electrically coupled to the power die 103, *e.g.,* to an electrode (*e.g.,* gate) of the die 103, through a second conductor portion 215 of a first coupling member. The component 209 is electrically coupled to the component bonding portion 1013_2 of the conductive layer 1013, for example, by compression bonding or through a conductive bonding material (*e.g.,* solder or conductive sintered piece) 133.

The spacer 205 has an end electrically coupled or attached to the die 103, for example, to an electrode (*e.g.,* source or drain) on a side of an upper surface of the die 103. In some embodiments, the spacer 205 may be attached to the die 103 by, for example, compression bonding; in other embodiments, the spacer may be electrically coupled to the die by a solder paste or sintered piece.

The pillar 211 has an end that may be bonded or coupled to the first mounting substrate 100. In some embodiments, the pillar 211 may be attached to an insulating body 1011 of the mounting substrate 100, as shown in FIG. 5A. In other embodiments, the pillar 211 may be attached to a conductive layer of the mounting substrate 100, as shown in FIG. 5B, which will be described below.

FIG. 5B shows a schematic cross-sectional view of a package structure according to another embodiment of the present disclosure. As shown in FIG. 5B, a package structure 50B may include a first mounting substrate 100 and an interposer substrate. In FIG. 5B, as an example, an interposer substrate 20B as shown in FIG. 2B is shown. The package structure 50B may have a power die 103. The power die 103 is electrically coupled to a die bonding portion 1013_1 of a conductive layer 1013 of the mounting substrate 100, for example, through a conductive bonding material 123. The die 103 is disposed between the interposer substrate 20A and the first mounting substrate 100. The component (first component) 207 is electrically coupled to the power die 103 through a second conductor portion 215 of a first coupling member, *e.g.,* to an electrode (*e.g.,* gate) of the die 103 through a conductive bonding material (*e.g.,* solder or conductive sintered piece) 107. Component 209 is electrically coupled to a component bonding portion 1013_2 of a conductive layer 1013, for example, through a conductive bonding material (*e.g.,* solder or conductive sintered piece) 133. The spacer 205 has an end electrically coupled or attached to the die 103, *e.g.,* to an electrode (*e.g.,* source or drain) on a side of an upper surface of the die 103 through a conductive bonding material (*e.g.,* solder or conductive sintered piece) 125. The pillar 211 has an end that may be bonded or electrically coupled to the conductive layer 1013 of the first mounting substrate 100.

FIG. 5C shows a schematic cross-sectional view of a package structure according to another embodiment of the present disclosure. The package structure 50C shown in FIG. 5C differs from the package structure 50B shown in FIG. 5B mainly in that, its interposer substrate is the interposer substrate 20I as shown in FIG. 2I, instead of the interposer substrate 20B in FIG. 5B.

FIGS. 6A, 6B, and 6C respectively show schematic cross-sectional views of package structures according to some embodiments of the present disclosure.

As shown in FIG. 6A, a second mounting substrate 200 is attached to the structure 50A shown in FIG. 5A. Similar to the mounting substrate 100, the mounting substrate 200 may include an insulating body 2011 and a conductive layer 2013 on a side (its lower surface in the orientation of FIG. 6A) of the insulating body 2011. The mounting substrate 200 may further include a conductive layer 2015 on the other side (its upper surface in the orientation of FIG. 6A) of the insulating body 2011. In some embodiments, the conductive layer 2013 may have a plurality of portions, such as a portion for attaching a spacer, a portion for attaching a pillar (if needed), etc. In some embodiments, as in the case of the first mounting substrate 100, it is also possible to attach an additional die to the second mounting substrate 200; and in this case, the conductive layer 2013 may also have a portion for attaching the die. In the example shown in FIG. 6A, the spacer 205 is attached to the conductive layer 2013 of the mounting substrate 200, for example, by compression bonding or through a conductive attachment material (not shown). The pillar 211 is attached to the insulating body 2011 of the mounting substrate 200, for example, through a bonding material or a sintered material (not shown).

In other implementations, there may further include an additional die (not shown) mounted to the second mounting substrate 200, which may be electrically coupled to other members in a similar manner to the die 103.

As shown in FIG. 6B, a second mounting substrate 200 is attached to the structure 50B shown in FIG. 5B. The mounting substrate 200 may include an insulating body 2011 and a conductive layer 2013 on a side (its lower surface in the orientation of FIG. 6B) of the insulating body 2011. The mounting substrate 200 may further include a conductive layer 2015 on the other side (its upper surface in the orientation of FIG. 6B) of the insulating body 2011. In the example shown in FIG. 6B, the spacer 205 is attached to a portion of the conductive layer 2013 of the mounting substrate 200, for example, by compression bonding or through a conductive attachment material (not shown). The pillar 211 is attached to another portion of the conductive layer 2013 of the insulating body 2011 of the mounting substrate 200, for example, by compression bonding or through a conductive attachment material (not shown).

As shown in FIG. 6C, a second mounting substrate 200 is attached to the structure 50C shown in FIG. 5C. The mounting substrate 200 may include an insulating body 2011 and a conductive layer 2013 on a side (its lower surface in the orientation of FIG. 6C) of the insulating body 2011. The mounting substrate 200 may further include a conductive layer 2015 on the other side (its upper surface in the orientation of FIG. 6C) of the insulating body 2011. In the example shown in FIG. 6C, the spacer 205 is attached to a portion of the conductive layer 2013 of the mounting substrate 200, for example, by compression bonding or through a conductive attachment material (not shown). The pillar 211 is attached to another portion of the conductive layer 2013 of the insulating body 2011 of the mounting substrate 200, for example, by compression bonding or through a conductive attachment material (not shown).

It will be readily understood by those skilled in the art that the package structures shown in FIGS. 5A-5C and 6A-6C may be attached and electrically coupled to a lead frame (not shown) and an encapsulant may be applied thereto for encapsulation.

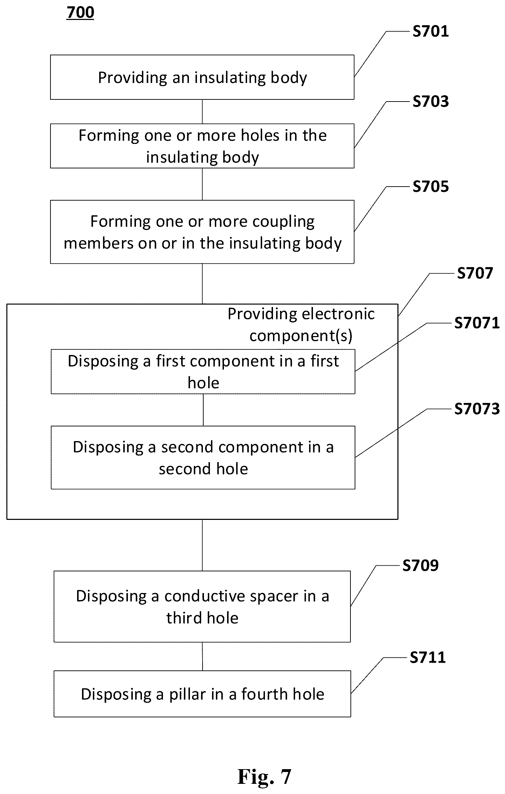

FIG. 7 shows a schematic flow chart of a manufacturing method of a package structure according to some embodiments of the present disclosure. A manufacturing method 700 of a package structure according to an embodiment of the present disclosure may include: providing or preparing an interposer substrate. As an example embodiment, providing or preparing an interposer substrate, as shown in FIG. 7, may include the following steps. In step S701, an insulating body, such as the insulating body 501 as shown in FIGS. 3A and 4A, is provided. In step S703, one or more holes are formed in the insulating body, for example as shown in FIGS. 3B and 4B. In step S705, one or more coupling members are formed on or in the insulating body, for example as shown in FIGS. 3C-3E and 4C-4E. In step S707, one or more electronic components are provided. The one or more electronic components may include a first electronic component (*e.g.,* component 207 or 209), for example, as shown in FIGS. 3F, 3H and FIGS. 4F, 4H. Optionally, in step S707, the one or more electronic components may further include a second electronic component (*e.g.,* component 209). In some implementations, providing one or more electronic components may include: in step S7071, disposing a first component (*e.g.,* component 207) is disposed in the first hole; and optionally, in step S7073, disposing a second component (*e.g.,* component 209) is disposed in the second hole. The first electronic component is disposed in the first hole of the one or more holes such that it is electrically coupled to a corresponding first coupling member of the one or more coupling members. The first electronic component is adapted to be electrically coupled to other members, such as a die or a mounting substrate, of the package structure external to the interposer substrate, through the first coupling member. The second electronic component (*e.g.,* component 209) may be disposed to be electrically coupled to a corresponding second coupling member of the one or more coupling members.

Optionally, in step S709, a conductive spacer may be disposed in a third hole, for example, as shown in FIGS. 3C, 4C-4E, etc. Optionally, in step S711, a pillar or support may be disposed in a fourth hole, for example, as shown in FIGS. 3C, 4C-4E, etc.

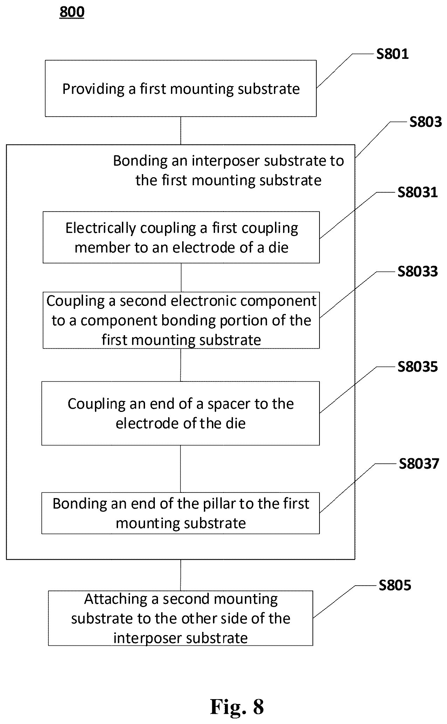

FIG. 8 shows a schematic flow chart of a manufacturing method of a package structure according to further embodiments of the present disclosure. A manufacturing method 800 of a package structure according to an embodiment of the present disclosure may include: in step S801, a first mounting substrate, such as the aforementioned mounting substrate 100, is provided. The first mounting substrate may include a die bonding portion and a power die electrically coupled to the die bonding portion. The first mounting substrate may further include a component bonding portion. In step S803, the interposer substrate is bonded to the first mounting substrate.

In some implementations, bonding the interposer substrate to the first mounting substrate may include: in step S8031, electrically coupling the first coupling member to an electrode of the die, so that a first electronic component is electrically coupled to the electrode of the die through the first coupling member. Optionally, in step S8033, a second electronic component may be electrically coupled to the component bonding portion of the first mounting substrate.

In some implementations, bonding the interposer substrate to the first mounting substrate may include: optionally, in step S8035, electrically coupling an end of a spacer to an electrode of the die, *e.g.,* to an electrode of the die on a side thereof opposite the first mounting substrate. Optionally, in step S8035, bonding an end of a pillar to the first mounting substrate, *e*.*g*., to a conductive layer or an insulating body of the mounting substrate.

The method 800 may further include: optionally, in step S805, attaching a second mounting substrate (e.g., mounting substrate 200) to a side of the interposer substrate opposite the first mounting substrate.

In some embodiments, the first component may include a gate resistor or a temperature sensing element, and the second component may include a temperature sensing element.

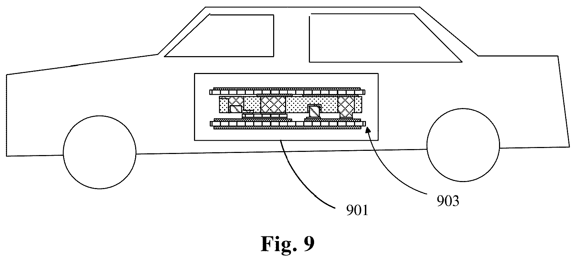

FIG. 9 shows a schematic diagram of an electrical system according to some embodiments of the present disclosure. The interposer substrates and package structures of embodiments of the present disclosure may be applied in a variety of electrical systems. The package structures according to the present disclosure may be used in various applications of power devices, such as, but not limited to, inverters, converters, power sources, power supply controllers, etc., and may also be applied to various apparatuses or systems, such as new energy vehicles, wind power systems, solar power generation systems, energy storage systems, etc. For example, as shown in FIG. 9, an electric vehicle as an electrical system may include an inverter or a power supply controller 901, which may include a package structure 903 according to the present disclosure or a power module (also labeled with 903) having the package structure according to the present disclosure (*e.g.,* which may be encapsulated with an encapsulant). The package structure/power module 903 may be a package structure according to any embodiment of the present disclosure and any variant that may be obtained from the present disclosure.

It will be appreciated by those skilled in the art that the present disclosure may employ a wide variety of power devices, such as, but not limited to, power MOSFETs, thyristors, power diodes. It will be appreciated by those skilled in the art that the boundaries between the operations (or steps) described in the above embodiments are merely illustrative. Multiple operations may be combined into a single operation, a single operation may be distributed in additional operations, and operations may be performed at least partially overlapping in time. Moreover, alternative embodiments may include multiple instances of a particular operation, and the order of operations may be altered in various other embodiments. And, other modifications, variations, and alternatives are also possible. Thus, the specification and drawings are provided in an illustrative rather than restrictive sense.

Although some specific embodiments of the present disclosure have been described in detail by way of examples, it should be understood by those skilled in the art that the above examples are for illustration only and are not intended to limit the scope of the present disclosure. The various embodiments disclosed herein or features thereof may be combined in any combination without departing from the spirit and scope of the disclosure. It will also be appreciated by those skilled in the art that various modifications might be made to the embodiments without departing from the scope and spirit of the present disclosure. The scope of the present disclosure is defined by the appended claims.

An interposer substrate for a package structure is summarized as including: an insulating body including one or more holes; one or more coupling members on the insulating body; and one or more electronic components including a first electronic component which is in a first hole of the one or more holes and electrically coupled to a corresponding first coupling member of the one or more coupling members, the first electronic component being adaptable to be electrically coupled to other coupling members of the package structure external to the interposer substrate through the first coupling member.

The package structure includes a power die adaptable to be coupled to a first mounting substrate and positioned between the interposer substrate and the first mounting substrate, and the first coupling member is adaptable to be electrically coupled to an electrode of the die.

The one or more electronic components further include a second electronic component in a second hole of the one or more holes, electrically coupled to a corresponding second coupling member of the one or more coupling members, and adaptable to be electrically coupled to a component bonding portion of the first mounting substrate through the corresponding second coupling member, wherein the die is coupled to a die bonding portion of the first mounting substrate.

The interposer substrate further includes at least one of: a conductive spacer in a third hole of the one or more holes, the spacer being adaptable to be electrically coupled to an electrode of the die on a side opposite to the first mounting substrate; or a pillar disposed in a fourth hole of the one or more holes, with an end thereof adaptable to be bonded to the first mounting substrate.

The first hole extends through the insulating body from a first face of the insulating body to a second face of the insulating body opposite the first face, the first coupling member includes a first conductor portion on the first face of the insulating body, an electrode of the first component, wherein the first conductor portion is adaptable to cover at least a portion of the first hole from a side of the first face of the insulating body and, the first conductor portion is electrically coupled to an electrode of the first component or to include a first portion of the first conductor portion at a sidewall of the first hole and the first portion is electrically coupled to the electrode of the first component.

The first hole extends through the insulating body from a first face of the insulating body to a second face of the insulating body opposite the first face, the first coupling member includes a first conductor portion including a first portion in the first hole, a second portion extending from the first portion to the first face of the insulating body along a sidewall of the first hole, and a third portion extending from the second portion along the first face of the insulating body, wherein the first portion or the second portion is electrically coupled to an electrode of the first component.

The first hole extends through the insulating body from a first face of the insulating body to a second face of the insulating body opposite the first face, the first coupling member includes a first conductor portion including a first portion and a second portion in the first hole and separated from the first portion, the first portion covering at least a portion of the first hole from a side of the first face of the insulating body, wherein the first portion is electrically coupled to an electrode of the first component.

The second hole extends through the insulating body from a first face of the insulating body to a second face of the insulating body opposite the first face, the second coupling member is in the second hole and extends from the first face of the insulating body to the second face of the insulating body, the second coupling member having a recess extending inward from the first face of the insulating body, the second component is at least partially provided in the recess and electrically coupled to the second coupling member.

The second hole extends inward from a first face of the insulating body and partially towards a second face of the insulating body opposite the first face; the second coupling member covers a surface of the second hole and has a recess extending inward from the first face of the insulating body, the second component is at least partially in the recess and electrically connected to the second coupling member.

The first component includes a gate resistor adaptable to be electrically coupled to a gate electrode of a die of the package structure through the first coupling member; or the second component includes a temperature sensing element adaptable to be electrically coupled to a mounting substrate of the package structure.

A package structure is summarized as including: an interposer substrate; a first mounting substrate including an insulating body and a conductive layer on a side of the insulating body; and a power die electrically coupled to a die bonding portion of the conductive layer, the die being between the interposer substrate and the first mounting substrate, wherein the first electronic component is electrically coupled, through the first coupling member, to one of: a conductive layer of the first mounting substrate; or an electrode of the power die.

The package structure further includes: a second mounting substrate provided opposite the first mounting substrate with the interposer substrate interposed therebetween.

A manufacturing method for a package structure is summarized as including: providing an interposer substrate including: providing an insulating body; forming one or more holes in the insulating body; forming one or more coupling members on or in the insulating body; and disposing one or more electronic components, wherein the one or more electronic components include a first electronic component disposed in a first hole of the one or more holes, electrically coupled to a corresponding first coupling member of the one or more coupling members, and adaptable to be electrically coupled to other members of the package structure external to the interposer substrate through the first coupling member.

The method further includes: providing a first mounting substrate which includes a die bonding portion and a power die electrically coupled to the die bonding portion; and bonding the interposer substrate to the first mounting substrate, wherein bonding the interposer substrate to the first mounting substrate includes: electrically coupling the first coupling member to an electrode of the die such that the first electronic component is electrically coupled to the electrode of the die through the first coupling member.

The one or more electronic components further include a second electronic component disposed in a second hole of the one or more holes and electrically coupled to a corresponding second coupling member of the one or more coupling members; bonding the interposer substrate to the first mounting substrate further includes: electrically coupling the second electronic component to a component bonding portion of the first mounting substrate.

Providing an interposer substrate further includes: disposing a conductive spacer in a third hole of the one or more holes; and disposing a pillar in a fourth hole of the one or more holes; bonding the interposer substrate to the first mounting substrate further includes: electrically coupling an end of the spacer to an electrode of the die on a side thereof opposite the first mounting substrate; and bonding an end of the pillar to the first mounting substrate.

The method further includes: attaching a second mounting substrate to a side of the interposer substrate opposite the first mounting substrate.

The first hole extends through the insulating body from a first face of the insulating body to a second face of the insulating body opposite the first face, the first coupling member includes a first conductor portion provided on or in the first face of the insulating body, and the first conductor portion includes a first portion at a sidewall of the first hole, the first portion being electrically connected to an electrode of the first component.

The first hole extends through the insulating body from a first face of the insulating body to a second face of the insulating body opposite the first face, the first coupling member includes a first conductor portion provided on or in the first face of the insulating body, wherein the first conductor portion covers at least a portion of the first hole from a side of the first face of the insulating body.

The first hole extends through the insulating body from a first face of the insulating body to a second face of the insulating body opposite the first face, the first coupling member includes a first conductor portion including a first portion filled in the first hole, a second portion extending from the first portion to the first face of the insulating body along a sidewall of the first hole, and a third portion extending from the second portion along the first face of the insulating body, wherein the first portion or the second portion is electrically connected to an electrode of the first component.

The first hole extends through the insulating body from a first face of the insulating body to a second face of the insulating body opposite the first face, the first coupling member includes a first conductor portion including a first portion and a second portion disposed in the first hole and separated from the first portion, the first portion covering at least a portion of the first hole from a side of the first face of the insulating body, and wherein the first portion is electrically connected to an electrode of the first component.

The second hole extends through the insulating body from a first face of the insulating body to a second face of the insulating body opposite the first face, the second coupling member is filled in the second hole and extends from the first face of the insulating body to the second face of the insulating body, the second coupling member having a recess extending inward from the first face of the insulating body, the second component is at least partially disposed in the recess and electrically connected to the second coupling member.

The second hole extends inward from a first face of the insulating body and does not extend to a second face of the insulating body opposite the first face, the second coupling member covers a surface of the second hole and has a recess extending inward from the first face of the insulating body, the second component is at least partially disposed in the recess and electrically connected to the second coupling member.

The first component includes a gate resistor adaptable to be electrically coupled to a gate electrode of the die through the first coupling member, or the second component includes a temperature sensing element.

An electrical system, which is summarized as including the package structure.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. An interposer substrate for a package structure comprising:
an insulating body including one or more holes;
one or more coupling members on the insulating body; and
one or more electronic components including a first electronic component which is in a first hole of the one or more holes and electrically coupled to a corresponding first coupling member of the one or more coupling members, the first electronic component being adaptable to be electrically coupled to other coupling members of the package structure external to the interposer substrate through the first coupling member.

2. The interposer substrate according to claim 1, wherein:
the package structure comprises a power die adaptable to be coupled to a first mounting substrate and positioned between the interposer substrate and the first mounting substrate, and
the first coupling member is adaptable to be electrically coupled to an electrode of the die.

3. The interposer substrate according to claim 2, wherein the one or more electronic components further comprise a second electronic component in a second hole of the one or more holes, electrically coupled to a corresponding second coupling member of the one or more coupling members, and adaptable to be electrically coupled to a component bonding portion of the first mounting substrate through the corresponding second coupling member,
wherein the die is coupled to a die bonding portion of the first mounting substrate.

4. The interposer substrate according to claim 2 or 3, further comprising at least one of:
a conductive spacer in a third hole of the one or more holes, the spacer being adaptable to be electrically coupled to an electrode of the die on a side opposite to the first mounting substrate; or
a pillar in a fourth hole of the one or more holes, with an end adaptable to be bonded to the first mounting substrate.

5. The interposer substrate according to claim 1, wherein
the first hole extends through the insulating body from a first face of the insulating body to a second face of the insulating body opposite the first face,
the first coupling member includes a first conductor portion on the first face of the insulating body,
an electrode of the first component;
wherein the first conductor portion is adaptable to cover at least a portion of the first hole from a side of the first face of the insulating body and the first conductor portion is electrically coupled to the electrode of the first component or to include a first portion of the first conductor portion at a sidewall of the first hole and the first portion is electrically coupled to the electrode of the first component.

6. The interposer substrate according to claim 1, wherein
the first hole extends through the insulating body from a first face of the insulating body to a second face of the insulating body opposite the first face,
the first coupling member includes a first conductor portion including a first portion in the first hole, a second portion extending from the first portion to the first face of the insulating body along a sidewall of the first hole, and a third portion extending from the second portion along the first face of the insulating body,
wherein the first portion or the second portion is electrically coupled to an electrode of the first component.

7. The interposer substrate according to claim 1, wherein
the first hole extends through the insulating body from a first face of the insulating body to a second face of the insulating body opposite the first face,
the first coupling member includes a first conductor portion including a first portion and a second portion in the first hole and separated from the first portion, the first portion covering at least a portion of the first hole from a side of the first face of the insulating body,
wherein the first portion is electrically coupled to an electrode of the first component.

8. The interposer substrate according to claim 3, wherein
the second hole extends through the insulating body from a first face of the insulating body to a second face of the insulating body opposite the first face,
the second coupling member is in the second hole and extends from the first face of the insulating body to the second face of the insulating body, the second coupling member having a recess extending inward from the first face of the insulating body,
the second component is at least partially provided in the recess and electrically coupled to the second coupling member.

9. The interposer substrate according to claim 3, wherein
the second hole extends inward from a first face of the insulating body and partially towards a second face of the insulating body opposite the first face; ,
the second coupling member covers a surface of the second hole and has a recess extending inward from the first face of the insulating body,
the second component is at least partially in the recess and electrically connected to the second coupling member.

10. The interposer substrate according to any one of claims 1 to 9, wherein
the first component includes a gate resistor adaptable to be electrically coupled to a gate electrode of a die of the package structure through the first coupling member; or
the second component includes a temperature sensing element adaptable to be electrically coupled to a mounting substrate of the package structure.

11. A package structure comprising:
an interposer substrate, including:
an insulating body;
a coupling member on the insulating body; and
a first electronic component in the insulating body and coupled to the coupling member;
a first mounting substrate including an insulating body, a first conductive layer on a side of the insulating body, and a second conductive layer on an opposing side of the insulating body; and
a power die electrically coupled to a die bonding portion of the conductive layer, the die being between the interposer substrate and the first mounting substrate
wherein the first electronic component is electrically coupled, through the coupling member to one of:
the second conductive layer of the first mounting substrate; or an electrode of the power die.

12. The package structure according to claim 11, further comprising:
a second mounting substrate provided opposite the first mounting substrate with the interposer substrate interposed therebetween.

13. A manufacturing method for a package structure comprising:
providing an interposer substrate comprising:
providing an insulating body;
forming one or more holes in the insulating body;
forming one or more coupling members on the insulating body; and
disposing one or more electronic components,
wherein the one or more electronic components include a first electronic component in a first hole of the one or more holes, electrically coupled to a corresponding first coupling member of the one or more coupling members, and adaptable to be electrically coupled to other members of the package structure external to the interposer substrate through the first coupling member.

14. The method according to claim 13, further comprising:
providing a first mounting substrate which includes a die bonding portion and a power die electrically coupled to the die bonding portion; and
bonding the interposer substrate to the first mounting substrate where the interposer substrate is adaptable to include a second mounting substrate on a side opposite to the first mounting substrate,
wherein bonding the interposer substrate to the first mounting substrate includes:
electrically coupling the first coupling member to an electrode of the die such that the first electronic component is electrically coupled to the electrode of the die through the first coupling member.

15. The method according to claim 14, wherein the one or more electronic components further includes a second electronic component in a second hole of the one or more holes and electrically coupled to a corresponding second coupling member of the one or more coupling members; and
bonding the interposer substrate to the first mounting substrate further includes: electrically coupling the second electronic component to a component bonding portion of the first mounting substrate.
